# EUROPEAN PATENT APPLICATION

(11) **EP 4 764 528 A1**
(43) Date of publication of application: **24.06.2026**
(21) Application number: 24879979.3
(22) Date of filing: 24.09.2024
(51) Int. Cl.: G01R 31/374, G01R 31/36, G01R 31/385, G01R 31/392, G01R 19/165, G01R 19/10

(54) **BATTERY DIAGNOSTIC DEVICE AND OPERATING METHOD THEREOF**

(30) Priority: 16.10.2023 KR 20230137948
(71) Applicant: LG Energy Solution, Ltd., Seoul 07335 (KR)
(72) Inventor: YU, Seung Yeop, Daejeon 34122 (KR); LEE, Sang Mu, Daejeon 34122 (KR)
(74) Representative: BCKIP Part mbB
(86) International application number: PCT/KR2024/014369
(87) International publication number: WO 2025/084640

(57) **Abstract**

A battery diagnosis apparatus according to an embodiment disclosed herein includes an information obtaining unit configured to obtain voltage information of each of a plurality of battery cells arranged in a tray and a controller configured to calculate a voltage drop value of each of the plurality of battery cells, based on the voltage information, correct the voltage drop value of each of the plurality of battery cells by using a reference value for correcting a voltage deviation with respect to a position in which each of the plurality of battery cells is arranged in the tray, and determine a state of each of the plurality of battery cells based on the corrected voltage drop value.

## Description

### TECHNICAL FIELD

### CROSS-REFERENCE TO RELATED APPLICATION

This application claims priority to and the benefit of Korean Patent Application No. 10-2023-0137948 filed in the Korean Intellectual Property Office on October 16, 2023, the entire content of which is incorporated herein by reference.

### TECHNICAL FIELD

Embodiments disclosed herein relate to a battery diagnosis apparatus and an operating method thereof.

### BACKGROUND ART

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

In terms of factors that may affect the quality of a battery during a manufacturing process of the battery, the battery may be diagnosed to sort a defective cell. In particular, in an activation process of the battery, a process of sorting a defective battery may be performed. In this case, when a plurality of battery cells are diagnosed according to an absolute criterion, there is a risk of non-detection and over-detection due to a deviation of each battery cell, etc.

### DISCLOSURE

### TECHNICAL PROBLEM

Embodiments disclosed herein aim to provide a battery diagnosis apparatus and an operating method thereof in which a characteristic deviation between battery cells may be corrected to perform diagnosis, thereby reducing non-detection and over-detection and improving diagnosis performance.

Technical problems of the embodiments disclosed herein are not limited to the above-described technical problems, and other unmentioned technical problems would be clearly understood by one of ordinary skill in the art from the following description.

### TECHNICAL SOLUTION

A battery diagnosis apparatus according to an embodiment disclosed herein includes an information obtaining unit configured to obtain voltage information of each of a plurality of battery cells arranged in a tray and a controller configured to calculate a voltage drop value of each of the plurality of battery cells, based on the voltage information, correct the voltage drop value of each of the plurality of battery cells by using a reference value for correcting a voltage deviation with respect to a position in which each of the plurality of battery cells is arranged in the tray, and determine a state of each of the plurality of battery cells based on the corrected voltage drop value.

According to an embodiment, the plurality of battery cells may be arranged in a matrix in the tray.

According to an embodiment, the reference value may be set based on voltage drop values of battery cells located in at least one column of the tray.

According to an embodiment, the reference value may include at least one of a median and an average of voltage drop values of battery cells located in at least one column of the tray.

According to an embodiment, the controller may be further configured to, for each column of the tray, correct the voltage drop value of each of the plurality of battery cells such that a median of voltage drop values of battery cells arranged in the corresponding column is the reference value.

According to an embodiment, the controller may be further configured to, for each column of the tray, correct a voltage drop value of each of battery cells located in the corresponding column by adding, to the voltage drop value, a difference between the reference value and the median of the voltage drop values of the battery cells located in the corresponding column.

According to an embodiment, the controller may be further configured to determine, as a defect, a battery cell having the corrected voltage drop value exceeding a threshold value.

According to an embodiment, the information obtaining unit may be further configured to obtain the voltage information of each of the plurality of battery cells in an activation process.

According to an embodiment, the controller may be further configured to, for each of the plurality of battery cells, calculate, as the voltage drop value, a difference between voltage values before and after a room-temperature aging process of the activation process.

According to an embodiment, the controller may be further configured to provide a result of the determination to a user.

A battery diagnosis method according to an embodiment disclosed herein includes obtaining voltage information of each of a plurality of battery cells arranged in a tray, calculating a voltage drop value of each of the plurality of battery cells, based on the voltage information, correcting the voltage drop value of each of the plurality of battery cells by using a reference value for correcting a voltage deviation with respect to a position in which each of the plurality of battery cells is arranged in the tray, and determining a state of each of the plurality of battery cells based on the corrected voltage drop value.

According to an embodiment, the plurality of battery cells may be arranged in a matrix in the tray, and the reference value may be set based on voltage drop values of battery cells located in at least one column of the tray.

According to an embodiment, the reference value may include at least one of a median and an average of voltage drop values of battery cells located in at least one column of the tray.

According to an embodiment, the correcting of the voltage drop value of each of the plurality of battery cells may include correcting, for each column of the tray, the voltage drop value of each of the plurality of battery cells such that a median of voltage drop values of battery cells arranged in the corresponding column is the reference value.

According to an embodiment, the correcting of the voltage drop value of each of the plurality of battery cells may include correcting, for each column of the tray, a voltage drop value of each of battery cells located in the corresponding column by adding, to the voltage drop value, a difference between the reference value and the median of the voltage drop values of the battery cells located in the corresponding column.

According to an embodiment, the determining of the state of each of the plurality of battery cells may include determining, as a defect, a battery cell having the corrected voltage drop value exceeding a threshold value.

According to an embodiment, the calculating of the voltage drop value of each of the plurality of battery cells may include calculating, as the voltage drop value, a difference between voltage values before and after a room-temperature aging process of the activation process, for each of the plurality of battery cells.

### ADVANTAGEOUS EFFECTS

A battery diagnosis apparatus and an operating method thereof according to embodiments disclosed herein may improve diagnosis performance of a battery cell by correcting a voltage drop value of each battery cell.

In addition, various effects identified directly or indirectly through this document may be provided.

### DESCRIPTION OF DRAWINGS

FIG. 1 shows a configuration of a battery diagnosis system according to an embodiment disclosed herein.
FIG. 2 shows an example of a temperature deviation of a battery tray, according to an embodiment disclosed herein.
FIG. 3 shows an example of correcting a voltage drop value of each battery cell, according to an embodiment disclosed herein.
FIG. 4 shows a rate at which a voltage drop value in a battery tray has a bell shape, according to an embodiment disclosed herein.
FIGS. 5A to 5C show a defect detection effect in voltage drop correction according to an embodiment disclosed herein.
FIG. 6 is a flowchart of a battery diagnosis method according to an embodiment disclosed herein.
FIG. 7 is a block diagram showing a hardware configuration of a computing system for performing an operating method of a battery diagnosis apparatus, according to an embodiment disclosed herein.

### MODE FOR INVENTION

Hereinafter, various embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

Herein, it is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

Each component (e.g., a module or a program) of the components described herein may include a single entity or multiple entities. According to various embodiments, one or more of the components may be omitted, or one or more other components may be added. Alternatively or additionally, a plurality of components (e.g., modules or programs) may be integrated into one component. In this case, the integrated component may perform one or more functions of each of the plurality of components in a manner that is the same as or similar to a corresponding component of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

As used herein, the term "module" or "...unit" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments of the present document may be implemented as software (e.g., a program or application) including one or more instructions that are stored in a storage medium (e.g., a memory) that is readable by a machine. For example, a processor of the machine may invoke at least one of the one or more instructions stored in the storage medium, and execute it, with or without using one or more other components under the control of the processor. This may enable the machine to operate to perform at least one function according to the at least one called instruction. The one or more instructions may include a code generated by a compiler or a code executable by an interpreter. A machine-readable storage medium may be provided in the form of a non-transitory storage medium. Herein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

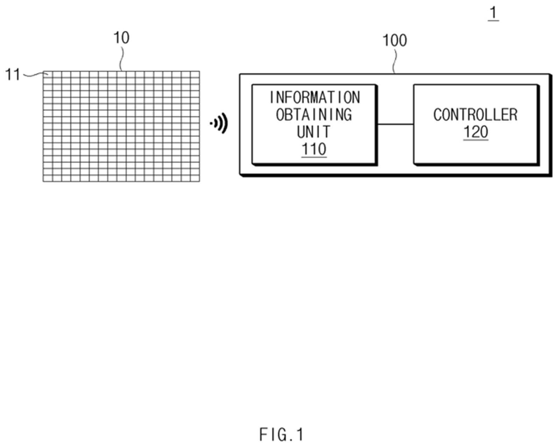

FIG. 1 shows a configuration of a battery diagnosis system according to an embodiment disclosed herein.

Referring to FIG. 1, a battery diagnosis system 1 may obtain voltage information of a plurality of battery cells 11 mounted on a tray 10 by using a battery diagnosis apparatus 100 and diagnose each state.

The battery diagnosis system 1 may correct a voltage drop value of each of the plurality of battery cells 11, considering a voltage deviation with respect to a temperature deviation in the tray 10, and diagnose each state based on the corrected voltage drop value, thereby reducing under-detection and over-detection and improving diagnosis performance.

In an embodiment, the battery diagnosis system 1 may diagnose the plurality of battery cells 11 in an activation process of the plurality of battery cells 11 arranged in the tray 10. An activation process of a battery is a process of giving electrical characteristics of the battery by repeating charging and discharging of the battery in a manufacturing process of the battery, and may be a process essentially included in manufacturing of the battery.

The plurality of battery cells 11 may undergo an aging process as a part of the activation process in which they are arranged in the tray 10 and stored at a specific temperature. The aging process may mean a process in which the battery is stored at a specific temperature for a specific period to allow an electrolyte to be uniformly distributed inside the battery and thus ions to move smoothly between a positive electrode and a negative electrode. In an embodiment, the aging process may include a room-temperature aging process in which room-temperature storage is made and a high-temperature aging process in which high-temperature storage is made.

In the aging process, the plurality of battery cells 11 may have temperature deviations with respect to positions thereof in the tray 10. For example, the plurality of battery cells 11 may have temperature deviations such as an increase in the temperature of the central portion of the tray 10 due to heat of a charger/discharger connected to the tray 10, heat transfer to the outside, sealing of the central portion, etc.

As the temperature is a major cause that affects a battery state such as a voltage behavior, etc., a temperature deviation occurring in the tray 10 may cause a deviation of characteristics (e.g., a voltage drop) of each battery cell. For example, battery cells located in the high-temperature central portion of the tray 10 may have a high voltage drop level, and battery cells located in the peripheral portion having the lower temperature than the central portion may have a low voltage drop level.

The tray 10 may have a structure in which the plurality of battery cells 11 may be accommodated, and the plurality of battery cells 11 may be arranged and accommodated in the tray 10. In an embodiment, the plurality of battery cells 11 may be arranged in a matrix in the tray 10. For example, the plurality of battery cells 11 may be regularly arranged in an n*m matrix (n and m are natural numbers) in the tray 10. This is merely an example and a form in which the plurality of battery cells 11 are arranged in the tray 10 is not limited thereto.

In an embodiment, the controller 120 may express voltage drop values of the plurality of battery cells 11 as a box plot. When the voltage drop values of the plurality of battery cells 11 are expressed as a box plot for each column of the tray 10, a tendency with respect to voltage drop deviations of the plurality of battery cells 11 may be identified.

The box plot may have a different form for each tray 10. For example, the box plot for the tray 10 may have a bell-shape form when the central portion has a high voltage drop and the peripheral portion has a low voltage drop. The box plot of the tray 10 may have various forms such as a bell-shape form, an one-side behavior decreasing form, and a tendency of a voltage drop such as a continuously decreasing form and a continuously increasing form. For example, the continuously increasing form of the box plot may include a form in which a position of a box in each column of the tray 10 continuously increases. When the box plot does not have a characteristic form such as a bell-shape form, the box plot may be classified as a normal form. That is, due to uniform temperature deviation and voltage drop deviation in the tray 10, the box plot may be classified as the normal form.

In this case, when diagnosis is performed by uniformly applying an absolute reference value to a tray having a box plot in a bell-shape form, etc., rather than a box plot having a normal form, over-detection and non-detection may occur due to a deviation between battery cells.

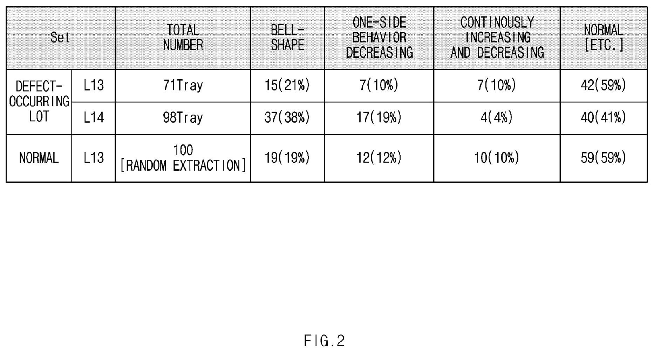

FIG. 2 shows an example of a rate of a box plot form of a battery tray, according to an embodiment disclosed herein.

Referring to FIG. 2, a rate of a form of a box plot in trays included in a battery lot may be identified. In the battery lot, a box plot may have the highest rate in the bell-shape form except for the normal form. In a lot where a defective cell occurs, a rate of a tray having the bell-shape form significantly increases when compared to a normal lot, i.e., a lot where a defective cell does not occur.

When the tray having the box plot in the bell-shape form significantly increases in the lot where the defective cell occurs, it may mean that for such a lot where the defective cell occurs, there is a high risk of non-detection and over-detection when diagnosis is performed by applying an absolute reference value.

Thus, to improve diagnosis performance in a tray having the bell-shape form, etc., the battery diagnosis system 1 may perform diagnosis by correcting voltage drop values of the plurality of battery cells 11 arranged in the tray 10.

Referring back to FIG. 1, the battery diagnosis apparatus 100 may include an information obtaining unit 110 and a controller 120.

The information obtaining unit 110 may obtain voltage information of each of the plurality of battery cells arranged in the tray 10. The information obtaining unit 110 may further obtain data such as not only voltage, but also current, temperature, state of charge (SOC), etc., of the battery.

The information obtaining unit 110 may obtain voltage information of each of the plurality of battery cells 11 in an activation process of the battery. More specifically, the information obtaining unit 110 may obtain voltage information of each of the plurality of battery cells 11 in an aging process of the activation process.

The information obtaining unit 110 may obtain battery information from, for example, a battery management system (BMS), a charger/discharger, or other equipment related to the plurality of battery cells.

The controller 120 may calculate a voltage drop value of each of the plurality of battery cells based on the voltage information. For example, the controller 120 may calculate a voltage drop value for a specific period from time-series voltage information obtained from the information obtaining unit 110. For example, the controller 120 may calculate, as a voltage drop value, a voltage drop level before and after the aging process for each of the plurality of battery cells.

According to an embodiment, the controller 120 may calculate, as a voltage drop value, a difference in voltage before and after the room-temperature aging process of the activation process for each of the plurality of battery cells 11. In the activation process of the battery, the aging process generally includes the room-temperature aging process and the high-temperature aging process in which the room-temperature aging process may be performed after the high-temperature aging process.

In this case, as the high-temperature aging process requires a short time and is performed before the room-temperature aging process, the controller 120 may use a voltage drop value of a battery cell for diagnosis before and after the room-temperature aging process to more accurately measure and reflect a voltage drop deviation with respect to a temperature deviation.

The controller 120 may correct a voltage drop value of each of the plurality of battery cells by using a reference value for correcting a voltage deviation with respect to a position in which each of the plurality of battery cells is arranged in the tray 10. As described above, the plurality of battery cells 11 may have a temperature deviation and thus a voltage deviation (more specifically, a voltage drop deviation may occur, in the tray 10. Thus, the controller 120 may correct a voltage drop value by considering a voltage deviation of each of the plurality of battery cells 11.

According to an embodiment, the reference value may be set based on voltage drop values of battery cells located in at least one column of the tray 10. The reference value may be set by the controller 120 and may be set by a component outside the battery diagnosis apparatus 100 or a user.

The controller 120 may correct a voltage deviation based on voltage drop values of battery cells located in at least one column. For example, the controller 120 may set a reference value by using voltage drop values of battery cells located in the central column, the first column, the last column, etc., of the tray 10.

According to an embodiment, the reference value may be set based on voltage drop values of the battery cells located in the central column of the tray 10. Herein, the central column of the tray 10 may mean a column located at the center of the columns of the tray 10. For example, when the tray 10 includes n columns (n is an odd natural number), the central column may mean a (n+1)/2-nd column. When the tray 10 includes m columns (m is an even natural number), the central column may be an m/2-nd column and/or an (m/2)+1-st column. For example, when the tray 10 includes 15 columns, the central column of the tray 10 may be an 8th column.

In another embodiment, the reference value may be set based on voltage drop values of battery cells arranged in k columns (k is a natural number of at least 2) located in the central portion of the tray 10. The controller 120 may also set the reference value according to various combinations of positions and number of columns in the tray 10.

According to an embodiment, the reference value may include at least one of a median and an average of voltage drop values of battery cells located in at least one column of the tray 10. The median may mean a value in the middle of the voltage drop values of the battery cells when the voltage drop values are arranged in a descending order or an ascending order. The average may mean an average of the voltage drop values of the battery cells. Depending on a circumstance, the reference value may include values calculated based on various operations such as a mode, a specific value (e.g., an average + a standard deviation, etc.) based on normal distribution, etc., as well as the median and the average.

For example, the controller 120 may set the median of the voltage drop values of the battery cells located in the central column of the tray 10.

According to an embodiment, the controller 120 may correct a voltage drop value of each of a plurality of battery cells such that for each column of the tray 10, a median of voltage drop values of battery cells arranged in the column is a reference value. For example, the controller 120 may perform fitting for each column of the tray 10 such that a voltage drop value of a battery cell corresponding to a median of the corresponding column is the reference value. For example, the controller 120 may adjust a distribution of voltage drop values such that a median of the voltage drop value of each battery cell is the reference value.

According to an embodiment, the controller 120 correct, for each column of the tray 10, a voltage drop value of each of battery cells located in the corresponding column by adding a difference (reference value - median) between the reference value and the median of the corresponding column to the voltage drop value. Through such correction, the controller 120 may fit the median as the reference value without harming overall voltage characteristics of the battery cells arranged in each column of the tray 10.

The controller 120 may determine a state of each of the plurality of battery cells based on the corrected voltage drop value. The controller 120 may correct the voltage drop values of the plurality of battery cells and perform diagnosis based on the corrected voltage drop value, thereby reducing a probability of non-detection and over-detection occurring.

According to an embodiment, the controller 120 may determine, as a defect, a battery cell having the corrected voltage drop value exceeding a threshold value. It may mean that the battery cell having the voltage drop value exceeding the threshold value has a higher voltage drop than a normal battery cell and thus may have voltage abnormality.

The threshold value may be experimentally and statistically set, and may be set based on a general voltage drop level of a battery cell. The threshold value may also be set according to positions and number of columns used for setting the reference value by the controller 120.

According to an embodiment, the controller 120 may provide a determination result of the plurality of battery cells to a user. Herein, the user may be, for example, a manager of the activation process of the battery.

When the controller 120 determines that the battery cell is abnormal as a result of diagnosis, the controller 120 may provide information about an abnormal battery cell to the user. For example, the controller 120 may provide information about the abnormal battery cell to a user terminal through a communication unit (not shown) and provide the information about the abnormal battery cell through a display provided in a vehicle, a charger, etc.

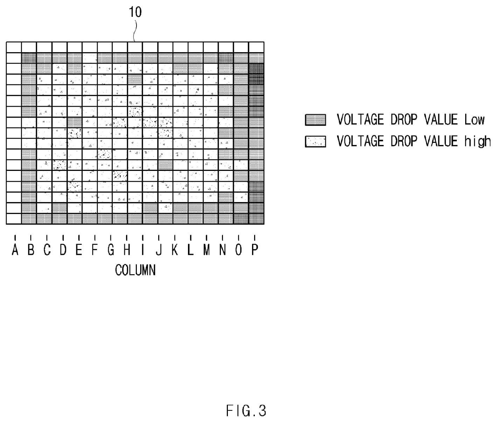

FIG. 3 shows an example of a temperature deviation of a battery tray, according to an embodiment disclosed herein.

Referring to FIG. 3, the plurality of battery cells 11 may be arranged in a matrix in the tray 10. In this case, the plurality of battery cells 11 may have a temperature deviation according to positions at which the plurality of battery cells 11 are arranged in the tray 10, and thus a voltage drop deviation may occur.

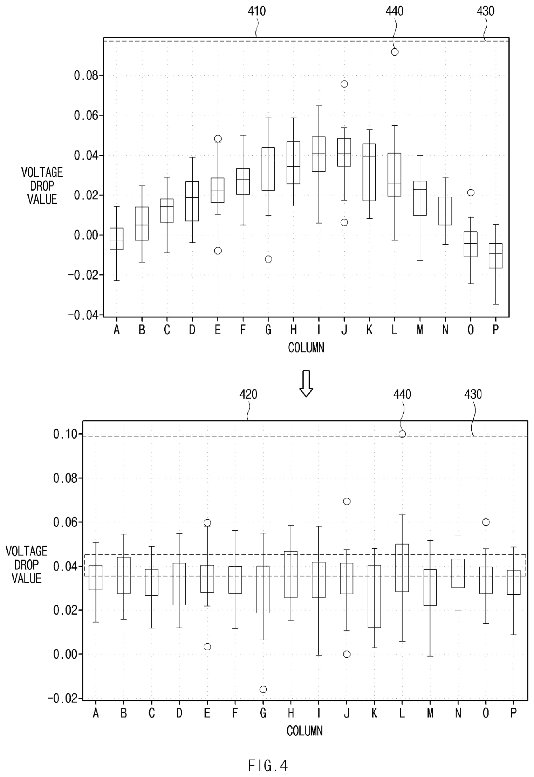

For example, the plurality of battery cells 11 may have temperature deviations such as an increase in the temperature of the central portion of the tray 10 due to heat of a charger/discharger connected to the tray 10, heat transfer to the outside, sealing of the central portion, etc. Thus, as shown in FIG. 4, battery cells located in the high-temperature central portion in the tray 10 may have a high voltage drop level and battery cells located in the peripheral portion having the lower temperature than the central portion may have a low voltage drop level. Arrangement and a tendency of a voltage drop deviation of the battery cells 11 shown in FIG. 3 are merely examples, and are not limited thereto.

FIG. 4 shows an example of correcting a voltage drop value of each battery cell, according to an embodiment disclosed herein.

Referring to FIG. 4, the controller 120 may express voltage drop values of the plurality of battery cells arranged in the tray 10 as a box plot. The controller 120 may express a voltage drop value of the battery cell 11 of each column of the tray 10 as a box plot. In the box plot, each column may express a reference section of - 25 % to + 25 % for a median as a box form, and may express a minimum value and a maximum value together.

A box plot 410 may show a voltage drop value of a tray (e.g., the tray of FIG. 3) having a bell-shape form for each column (columns A to P). Referring to the box plot 410, when comparison with a threshold value 430 is performed in a general diagnosis process, a specific battery cell 440, even being a defect, may not be detected as a defect (non-detection).

To prevent such a case, the controller 120 may correct the voltage drop values of the plurality of battery cells 11 based on the reference value. The box plot 420 may indicate a box plot after a voltage drop value is corrected.

Referring to the box plot 420, it may be seen that the battery cell 440 not detected in an existing manner for the same threshold value 430 is detected as a defect.

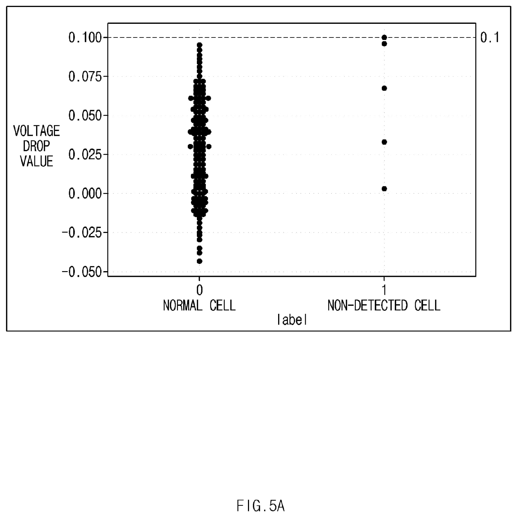

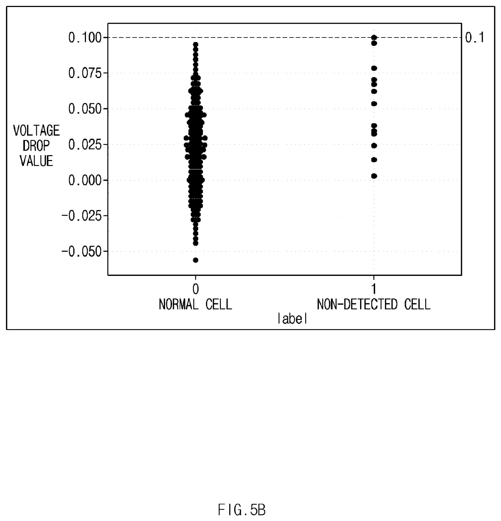

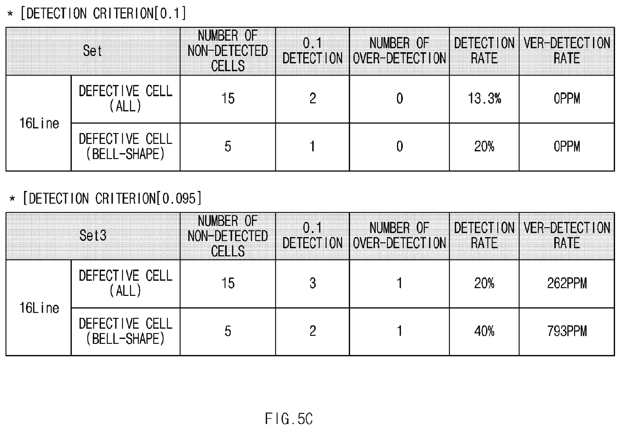

FIG. 5A shows an example of a non-detected cell in trays having a bell-shape form in diagnosis using an existing diagnosis scheme. FIG. 5B shows an example of a non-detected cell in all the trays in diagnosis using an existing scheme. FIG. 5C is a view showing a diagnosis effect of a battery diagnosis apparatus according to an embodiment disclosed herein.

FIG. 5A shows voltage drop values of a normal cell and a non-detected cell in trays having a bell-shape form, and FIG. 5B shows voltage drop values of a normal cell and a non-detected cell in trays having any form. Referring to FIGS. 5A and 5B, when a battery is diagnosed using an existing scheme, 5 cells are not detected in the trays having the bell-shape form and 15 cells are not detected in all the trays.

FIG. 5C shows a diagnosis result of the battery cells shown in FIGS. 5A and 5B by using the battery diagnosis apparatus 100 according to an embodiment disclosed herein. Referring to FIG. 5C, when a battery cell is diagnosed using the battery diagnosis apparatus 100 according to an embodiment disclosed herein, for a threshold value of 0.1, 1 cell may be further detected in the bell-shape form and 2 cells may be further detected in all the trays. That is, when diagnosis is performed using the battery diagnosis apparatus 100 according to an embodiment disclosed herein, diagnosis performance may be improved.

For a threshold value of 0.95, 2 cells for the bell-shape form and 3 cells for all the trays may be further detected. However, in this case, over-detection may occur for 1 cell, but this may improve diagnosis performance through adjustment of the threshold value and reduce occurrence of over-detection.

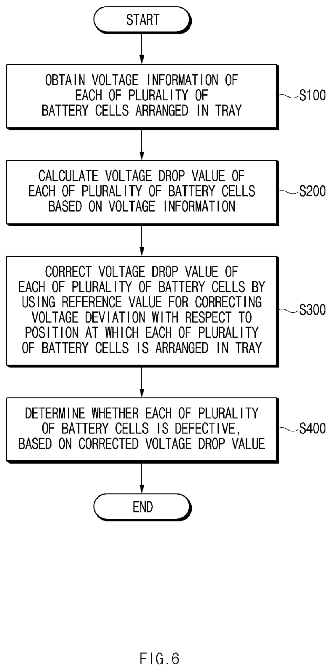

FIG. 6 is a flowchart of a battery diagnosis method according to an embodiment disclosed herein.

Referring to FIG. 6, the battery diagnosis method may include operation S100 of obtaining voltage information of each of a plurality of battery cells arranged in a tray, operation S200 of calculating a voltage drop value of each of the plurality of battery cells based on the voltage information, operation S300 of correcting the voltage drop value of each of the plurality of battery cells by using a reference value for correcting a voltage deviation according to a position at which each of the plurality of battery cells is arranged in the tray, and operation S400 of determining a state of each of the plurality of battery cells based on the corrected voltage drop value.

In operation S100, the information obtaining unit 110 may obtain voltage information of each of the plurality of battery cells arranged in the tray 10. In an embodiment, the information obtaining unit 110 may obtain voltage information of each of the plurality of battery cells in an activation process.

In operation S200, the controller 120 may calculate a voltage drop value of each of the plurality of battery cells. In an embodiment, the controller 120 may calculate, as a voltage drop value, a difference between voltage values before and after a room-temperature aging process of the activation process for each of the plurality of battery cells.

In operation S300, the controller 120 may correct the voltage drop value of each of the plurality of battery cells by using a reference value. In an embodiment, the controller 120 may correct the voltage drop values of the plurality of battery cells based on a median of battery cells located in the central column of the tray 10.

In operation S400, the controller 120 may determine a state of each of the plurality of battery cells based on the corrected voltage drop value. The state of each battery cell may include whether the battery cell is defective.

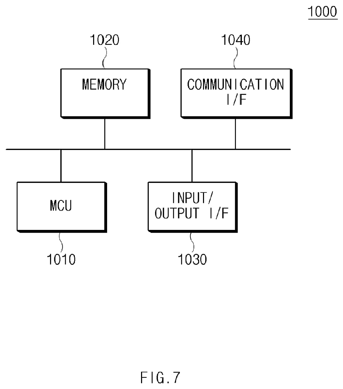

FIG. 7 is a block diagram showing a hardware configuration of a computing system for performing an operating method of a battery diagnosis apparatus, according to an embodiment disclosed herein.

Referring to FIG. 7, a computing system 1000 according to an embodiment disclosed herein may include a microcontroller unit (MCU) 1010, a memory 1020, an input/output interface (I/F) 1030, and a communication I/F 1040.

The MCU 1010 may be a processor that executes various programs (e.g., a voltage drop calculation program, a voltage drop correction program, and a state determination program) stored in the memory 1020, processes various information including a discharging voltage of the battery, etc., through these programs, and executes the above-described functions of the controller included in the battery diagnosis apparatus shown in FIG. 1.

The memory 1020 may store various programs such as the voltage drop calculation program, the voltage drop correction program, the state determination program, etc. Moreover, the memory 1020 may store various information such as voltage information of the battery, etc.

The memory 1020 may be provided in plural, depending on a need. The memory 1020 may be a volatile or nonvolatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., with the MCU 1010.

The communication I/F 1040, which is a component capable of transmitting and receiving various data to and from a server, may be various types of devices capable of supporting wired or wireless communication. For example, the battery diagnosis apparatus may transmit and receive various information including voltage information, etc., of the battery from an external server separately provided through the communication I/F 1040.

As such, a computer program according to an embodiment disclosed herein may be recorded in the memory 1020 and processed by the MCU 1010, thus being implemented as a module that performs functions shown in FIG. 1.

Even though all components constituting an embodiment disclosed herein have been described above as being combined into one or operating in combination, the embodiments disclosed herein are not necessarily limited to the embodiment. That is, within the object scope of the embodiments disclosed herein, all the components may operate by being selectively combined into one or more.

Moreover, terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

The above description is merely illustrative of the technical idea disclosed herein, and various modifications and variations will be possible without departing from the essential characteristics of the embodiments disclosed herein by those of ordinary skill in the art to which the embodiments disclosed herein pertains. Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of this document.

## Claims

1. A battery diagnosis apparatus comprising:
an information obtaining unit configured to obtain voltage information of each of a plurality of battery cells arranged in a tray; and
a controller configured to:
calculate a voltage drop value of each of the plurality of battery cells, based on the voltage information;
correct the voltage drop value of each of the plurality of battery cells by using a reference value for correcting a voltage deviation with respect to a position in which each of the plurality of battery cells is arranged in the tray; and
determine a state of each of the plurality of battery cells based on the corrected voltage drop value.

2. The battery diagnosis apparatus of claim 1, wherein the plurality of battery cells are arranged in a matrix in the tray.

3. The battery diagnosis apparatus of claim 2, wherein the reference value is set based on voltage drop values of battery cells located in at least one column of the tray.

4. The battery diagnosis apparatus of claim 3, wherein the reference value comprises at least one of a median and an average of voltage drop values of battery cells located in at least one column of the tray.

5. The battery diagnosis apparatus of claim 2, wherein the controller is further configured to, for each column of the tray, correct the voltage drop value of each of the plurality of battery cells such that a median of voltage drop values of battery cells arranged in the corresponding column is the reference value.

6. The battery diagnosis apparatus of claim 5, wherein the controller is further configured to, for each column of the tray, correct a voltage drop value of each of battery cells located in the corresponding column by adding, to the voltage drop value, a difference between the reference value and the median of the voltage drop values of the battery cells located in the corresponding column.

7. The battery diagnosis apparatus of claim 1, wherein the controller is further configured to determine, as a defect, a battery cell having the corrected voltage drop value exceeding a threshold value.

8. The battery diagnosis apparatus of claim 1, wherein the information obtaining unit is further configured to obtain the voltage information of each of the plurality of battery cells in an activation process.

9. The battery diagnosis apparatus of claim 8, wherein the controller is further configured to, for each of the plurality of battery cells, calculate, as the voltage drop value, a difference between voltage values before and after a room-temperature aging process of the activation process.

10. The battery diagnosis apparatus of claim 1, wherein the controller is further configured to provide a result of the determination to a user.

11. A battery diagnosis method comprising:
obtaining voltage information of each of a plurality of battery cells arranged in a tray;
calculating a voltage drop value of each of the plurality of battery cells, based on the voltage information;
correcting the voltage drop value of each of the plurality of battery cells by using a reference value for correcting a voltage deviation with respect to a position in which each of the plurality of battery cells is arranged in the tray; and
determining a state of each of the plurality of battery cells based on the corrected voltage drop value.

12. The battery diagnosis method of claim 11, wherein the plurality of battery cells are arranged in a matrix in the tray, and
the reference value is set based on voltage drop values of battery cells located in at least one column of the tray.

13. The battery diagnosis method of claim 12, wherein the reference value comprises at least one of a median and an average of voltage drop values of battery cells located in at least one column of the tray.

14. The battery diagnosis method of claim 12, wherein the correcting of the voltage drop value of each of the plurality of battery cells comprises correcting, for each column of the tray, the voltage drop value of each of the plurality of battery cells such that a median of voltage drop values of battery cells arranged in the corresponding column is the reference value.

15. The battery diagnosis method of claim 14, wherein the correcting of the voltage drop value of each of the plurality of battery cells comprises correcting, for each column of the tray, a voltage drop value of each of battery cells located in the corresponding column by adding, to the voltage drop value, a difference between the reference value and the median of the voltage drop values of the battery cells located in the corresponding column.

16. The battery diagnosis method of claim 11, wherein the determining of the state of each of the plurality of battery cells comprises determining, as a defect, a battery cell having the corrected voltage drop value exceeding a threshold value.

17. The battery diagnosis method of claim 11, wherein the calculating of the voltage drop value of each of the plurality of battery cells comprises calculating, as the voltage drop value, a difference between voltage values before and after a room-temperature aging process of the activation process, for each of the plurality of battery cells.
